# EUROPEAN PATENT APPLICATION

(11) **EP 4 765 311 A1**
(43) Date of publication of application: **24.06.2026**
(21) Application number: 25222927.3
(22) Date of filing: 12.12.2025
(51) Int. Cl.: H01M 10/42, H01M 10/48, H01M 10/613, H01M 10/6555, H01M 10/6557

(54) **BATTERY ASSEMBLY**

(30) Priority: 13.12.2024 KR 20240186172
(71) Applicant: SK On Co., Ltd., Seoul 03161 (KR)
(72) Inventor: HAN, Jin Su, 34124 Daejeon (KR); CHO, Sei Hoon, 34124 Daejeon (KR); SHIM, Hyun Bin, 34124 Daejeon (KR)
(74) Representative: Stolmár & Partner Patentanwälte PartG mbB

(57) **Abstract**

The present disclosure relates to a battery assembly. Such a battery assembly includes a case in which a receiving space is formed inside, a plurality of battery cells stacked in a predetermined direction, and a cell assembly accommodated in the receiving space. The cell assembly includes a printed wiring circuit board for measuring a voltage of at least one of the battery cells, and a cooling plate which is formed of an electrically conductive material, has a flow path formed therein through which a cooling material moves, and is disposed to face the battery cells. One electrode of each of the battery cells is electrically connected to the printed wiring circuit board through the cooling plate, and the other electrode of each of the battery cells is formed to be electrically connected to the printed wiring circuit board.

## Description

### BACKGROUND OF THE INVENTION

### 1. Field

Embodiments of the present disclosure relates to a battery assembly, and more particularly to a battery assembly including a cell assembly configured such that a current for measuring a voltage of a battery cell can flow through a cooling plate.

### 2. Description of the Related Art

A battery cell includes an electrode assembly in which a positive electrode plate and a negative electrode plate, on which a positive electrode active material and a negative electrode active material are respectively applied, are disposed with a separator interposed therebetween, and an exterior material that seals and accommodates the electrode assembly together with an electrolyte.

Recently, as the need for large-capacity structures has increased along with utilization as an energy storage source, demand has been increasing for battery assemblies such as a battery module including a plurality of battery cells electrically connected in series and/or in parallel and accommodating such battery cells therein, and a battery management system (BMS).

Such a battery assembly may also be provided with a sensor for measuring voltages of the plurality of battery cells in order to manage the plurality of battery cells.

Specifically, a cell assembly (hereinafter referred to as a cell assembly) in which a plurality of battery cells are stacked is provided with a printed circuit board (PCB) electrically connected to one electrode of each of the battery cells on one side, and another printed circuit board on the other side of the cell assembly, and is configured such that a flexible printed circuit board (FPCB) connects the two printed circuit boards so that the voltage of each of the battery cells is measured through one of the printed circuit boards.

As such, when the cell assembly is configured to have printed circuit boards on both one side and the other side and further to have a flexible printed circuit board for connecting the two printed circuit boards, a separate space for installing the printed circuit boards and the flexible printed circuit board is required.

That is, since the space inside the battery assembly for installing the printed circuit boards and the flexible printed circuit board cannot be utilized, it becomes impossible to arrange a larger number of battery cells inside the battery assembly, which makes it difficult to increase the energy density of the battery assembly.

Therefore, it is necessary to develop a battery assembly capable of increasing energy density by minimizing the volume of the space for installing the printed circuit boards and the flexible printed circuit board.

### SUMMARY OF THE INVENTION

An object of the present disclosure is to provide a battery assembly capable of increasing energy density.

Another object of the present disclosure is to provide a battery assembly capable of effectively discharging gas emitted from a battery cell to the outside of the battery assembly.

Still another object of the present disclosure is to provide a battery assembly in which deformation of a shape of a case caused by expansion of the battery cell is prevented.

The battery assembly of the present disclosure can be widely used in the green technology field utilizing batteries, such as electric vehicles. In addition, the battery assembly of the present disclosure can be used in eco-friendly electric vehicles, hybrid vehicles, and the like, which suppress air pollution and greenhouse gas emissions to prevent climate change.

As a technical means for solving the above-described technical problems, a battery assembly according to one embodiment of the present disclosure may comprise a case in which a receiving space is formed inside, a plurality of battery cells stacked in a predetermined direction, and a cell assembly accommodated in the receiving space. The cell assembly may include a printed wiring circuit board for measuring a voltage of at least one of the battery cells, and a cooling plate which is formed of an electrically conductive material, has a flow path formed therein through which a cooling material moves, and is disposed to face the battery cells, wherein one electrode of each of the battery cells is electrically connected to the printed wiring circuit board through the cooling plate, and the other electrode of each of the battery cells may be electrically connected to the printed wiring circuit board.

In addition, the cell assembly may comprise a first busbar assembly and the printed wiring circuit board, the first busbar assembly being disposed on one side of the cell assembly to electrically connect one electrode of each of the battery cells and one side of the cooling plate, and the printed wiring circuit board being coupled thereto, and a second busbar assembly disposed on the other side of the cell assembly to electrically connect the other electrode of each of the battery cells and the printed wiring circuit board, and to electrically connect the other side of the cooling plate and the printed wiring circuit board, wherein the second busbar assembly can electrically connect one electrode of each of the battery cells and the printed wiring circuit board by electrically connecting the other side of the cooling plate and the printed wiring circuit board.

In addition, the first busbar assembly may include a plurality of first electrically conductive members for electrically connecting one electrode of each of the battery cells and one side of the cooling plate.

In addition, the first electrically conductive member may have one side coupled to the first busbar assembly and the other side coupled to one side of the cooling plate.

In addition, the first electrically conductive member may be formed as a first bolt screwed to the first busbar assembly and the cooling plate.

In addition, the second busbar assembly may include a plurality of second electrically conductive members for electrically connecting the printed wiring circuit board and the other side of the cooling plate.

In addition, the second electrically conductive member may have one side coupled to the other side of the cooling plate and the other side coupled to the printed wiring circuit board, and at least a part thereof may be supported by the second busbar assembly.

In addition, the second electrically conductive member may be formed as a second bolt screwed to the printed wiring circuit board, the second busbar assembly, and the cooling plate.

In addition, a plurality of the cooling plates may be disposed such that one surface and the other surface thereof face the battery cells, and each of the battery cells may be disposed such that at least one surface thereof faces the cooling plate.

In addition, each of the battery cells may be formed such that an exhaust hole for discharging gas is formed on a surface facing the lower plate, and the lower plate may be formed with a communication hole communicating with the outside of the case so that the gas discharged from the exhaust hole is discharged to the outside of the case.

In addition, the cell assembly may be configured such that the exhaust hole is formed at a position facing the communication hole, a portion of a lower surface of the cell assembly except for a portion facing the communication hole is bonded to the lower plate by being coupled with an adhesive layer, a first sealing member is coupled to an upper surface facing the upper plate, and a second sealing member is coupled to a portion adjacent to one electrode and a portion adjacent to the other electrode of each of the battery cells.

In addition, at least a part of a remaining space of the receiving space, except for a space in which the cell assembly is disposed, may be filled with a flame-retardant material.

In addition, the flame-retardant material may include silica gel.

In addition, a first buffer member may be installed on an inner circumferential surface of a first plate located at one end in the predetermined direction of the side plates in which the plurality of battery cells are stacked, and a second buffer member may be installed on an inner circumferential surface of a second plate located at the other end in the predetermined direction of the side plates, wherein the first buffer member and the second buffer member may be formed to be compressed by being pressed by the cell assembly when the plurality of battery cells expand and a volume of the cell assembly increases.

In addition, an inlet through which the cooling material flows in and an outlet through which the cooling material is discharged may be formed in the case, and the inlet and the outlet may be communicated with the flow path formed in each of the cooling plates, so that the cooling material introduced through the inlet may move along the flow path and be discharged through the outlet.

Specific details of other embodiments for achieving the objects are included in the description of the invention and drawings.

According to the means for solving the problems of the present disclosure as described above, the battery assembly according to the present disclosure provides an effect of being capable of increasing the energy density of the battery assembly, since the cell assembly is configured to be provided with one flexible printed circuit board, thereby accommodating a larger number of battery cells inside the battery assembly.

In addition, since each of the battery cells is configured to discharge gas toward the lower plate in which the communication hole is formed, an effect of effectively discharging the gas emitted from the battery cell to the outside of the battery assembly is provided.

In addition, since a buffer member that contracts in response to an increase in volume of the cell assembly is installed in the case, an effect of preventing deformation of the shape of the case caused by expansion of the battery cell is provided.

### BRIEF DESCRIPTION OF THE DRAWINGS

FIG. 1 is an exploded perspective view of a battery assembly according to an embodiment of the present disclosure.
FIG. 2 is a view showing a receiving space formed by a lower plate and side plates.
FIG. 3 is a view showing a state in which a buffer member is installed inside the battery assembly.
FIG. 4 is a view showing a part of a cell assembly such that one end of the cell assembly is visible.
FIG. 5 is a view showing a part of a cell assembly such that the other end of the cell assembly is visible.
FIG. 6 is a view showing the cell assembly as viewed from a direction perpendicular to a direction in which a plurality of battery cells are stacked.
FIG. 7 is a view showing the cell assembly of FIG. 6 including an electrically conductive member formed as a bolt.
FIG. 8 is a view schematically showing a conventional cell assembly capable of measuring a voltage of a battery cell.
FIG. 9 is a view schematically showing a cell assembly of the battery assembly according to an embodiment of the present disclosure.
FIG. 10 is a view showing a cell assembly in which an adhesive layer, a first sealing member, and a second sealing member are coupled.

### DETAILED DESCRIPTION

Hereinafter, embodiments of the present application will be described in detail with reference to the accompanying drawings so that those skilled in the art to which the present application pertains can easily implement the present application. However, the present application may be embodied in many different forms and is not limited to the embodiments described herein. In the drawings, in order to clearly describe the present application, parts irrelevant to the description are omitted, and like reference numerals are assigned to like parts throughout the specification.

Throughout the specification, when a part is described as being "connected" to another part, this includes not only a case where the part is "directly connected" but also a case where the part is "electrically connected" with another element interposed therebetween.

Throughout the specification, when a member is described as being "on" another member, this includes not only a case where the member is in contact with the other member but also a case where another member is interposed therebetween.

Throughout the specification, when a part is described as "including" a component, this means that unless otherwise stated, the part does not exclude other components but may further include other components. Throughout the specification, terms indicating degree, such as "about" and "substantially," are used in the sense of being at or near the numerical value when a manufacturing and material tolerance inherent to the mentioned meaning is presented, and are used to prevent an unscrupulous infringer from unfairly taking advantage of disclosed content in which exact or absolute numerical values are mentioned to aid understanding of the present application. Throughout the specification, the terms "~ step" or "the step of ~" do not mean "a step for ~."

Hereinafter, preferred embodiments of the present disclosure will be described in detail with reference to the accompanying drawings and the content described below. However, the present disclosure is not limited to the embodiments described herein and may be embodied in other forms. Throughout the specification, the same reference numerals denote the same components.

In the following, a configuration of a battery assembly according to an embodiment of the present disclosure will be described.

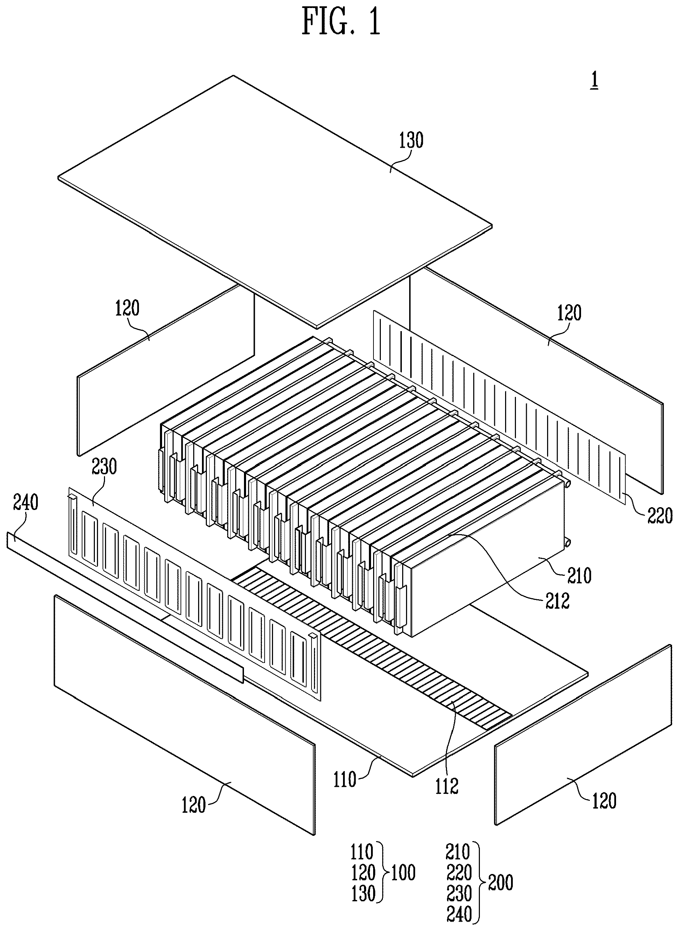

FIG. 1 is an exploded perspective view of a battery assembly according to an embodiment of the present disclosure.

Referring to FIG. 1, a battery assembly 1 includes a case 100 and a cell assembly 200.

First, the case 100 will be described.

The case 100 may have a receiving space S formed therein.

Specifically, as shown in FIG. 1, the case 100 includes a lower plate 110, side plates 120 connected to the lower plate 110 to form the receiving space S together with the lower plate 110, and an upper plate 130 coupled to the side plates 120 to seal the receiving space S.

The lower plate 110 may form a lower portion of the case 100 constituting an exterior of the battery assembly 1, and may be formed as a plate having a plate shape.

In addition, the lower plate 110 may be formed with a communication hole 112 communicating with the outside of the case 100. The communication hole 112 may be composed of a plurality of holes formed along a predetermined direction.

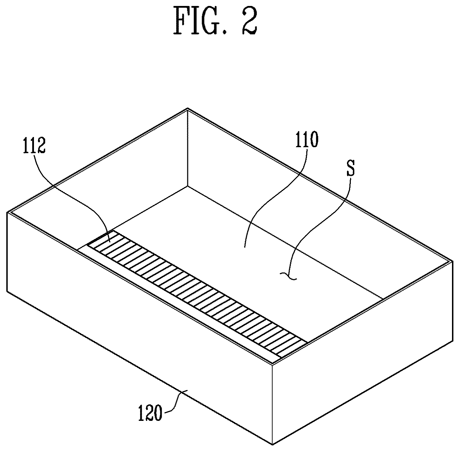

FIG. 2 is a view showing a receiving space formed by a lower plate and side plates.

The side plates 120 may form side portions of the case 100 constituting an exterior of the battery assembly 1, and, as shown in FIG. 2, may be connected to the lower plate 110 to form the receiving space S together with the lower plate 110.

The side plates 120 may be formed separately from the lower plate 110 and coupled to the lower plate 110, but may also be formed integrally with the lower plate 110 so as to be connected to the lower plate 110.

Meanwhile, a buffer member may be installed on an inner circumferential surface of the side plates 120, which contracts as a volume of the cell assembly 200, to be described later, increases, thereby preventing deformation of the shape of the case 100.

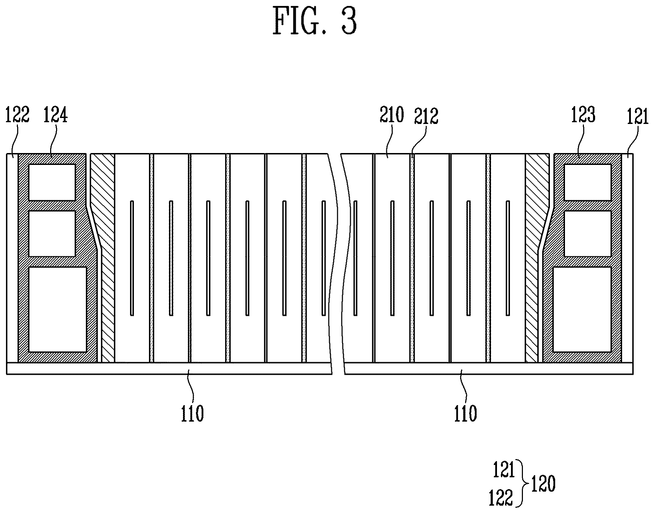

FIG. 3 is a view showing a state in which a buffer member is installed inside the battery assembly.

For example, as shown in FIG. 3, the side plates 120 may be assembled so that a predetermined space is provided between the side plates 120 and the cell assembly 200, and buffer members 123 and 124 may be disposed in the predetermined space.

That is, a first buffer member 123 may be installed on an inner circumferential surface of a first plate 121 located at one end in a predetermined direction of the side plates 120 in which a plurality of battery cells 210 are stacked, and a second buffer member 124 may be installed on an inner circumferential surface of a second plate 122 located at the other end in the predetermined direction of the side plates 120.

At this time, the first buffer member 123 and the second buffer member 124 may be respectively formed in shapes capable of filling a space formed between one end of the cell assembly 200 and the first plate 121 and a space formed between the other end of the cell assembly 200 and the second plate 122, and may be formed to be compressed by being pressed by the cell assembly 200 when the plurality of battery cells 210 expand and a volume of the cell assembly 200 increases.

The upper plate 130 may form an upper portion of the case 100 constituting an exterior of the battery assembly 1, and may be formed as a plate having a plate shape.

The upper plate 130 may be coupled to the side plates 120 to seal the receiving space S.

Meanwhile, an inlet through which a cooling material flows in and an outlet through which the cooling material is discharged may be formed in the case 100. The inlet and the outlet may be communicated with a flow path formed in each of cooling plates 212, which will be described later, so that the cooling material introduced through the inlet may move along the flow path and be discharged through the outlet.

In addition, at least a part of a remaining space of the receiving space S, except for a space in which the cell assembly 200 is disposed, may be filled with a flame-retardant material.

That is, in order to prevent fire generated in the cell assembly 200 from spreading, the receiving space S may be filled with a flame-retardant material, which may be formed to include silica gel, but the composition of the flame-retardant material is not limited thereto.

Next, the cell assembly 200 will be described.

As shown in FIG. 1, the cell assembly 200 may include a plurality of battery cells 210 stacked in a predetermined direction, cooling plates 212, a first busbar assembly 220, a second busbar assembly 230, and a printed wiring circuit board 240, and may be accommodated in the receiving space.

The battery cell 210 may include an electrode assembly and an exterior material accommodating the electrode assembly.

The electrode assembly may be an assembly of electrode plates coated with an electrode active material and a separator, and may be configured such that one or more positive electrode plates and one or more negative electrode plates are disposed with the separator interposed therebetween.

A positive electrode tab is provided on the positive electrode plate of the electrode assembly, and one or more positive electrode tabs may be connected to a positive electrode lead. The positive electrode lead is connected at one end to the positive electrode tab and is exposed at the other end to the outside of the battery cell, and the exposed portion may function as a positive electrode terminal of the secondary battery.

A negative electrode tab is provided on the negative electrode plate of the electrode assembly, and one or more negative electrode tabs may be connected to a negative electrode lead. The negative electrode lead is connected at one end to the negative electrode tab and is exposed at the other end to the outside of the battery cell, and the exposed portion may function as a negative electrode terminal of the secondary battery.

The exterior material may be formed of a pouch or the like, and depending on the type of exterior material, the battery cell 210 may be formed as a pouch-type secondary battery, a prismatic secondary battery, or the like.

The cooling plate 212 may have a flow path formed therein through which a cooling material moves, may be formed of an electrically conductive material, and may be disposed to face the battery cell 210.

For example, a plurality of the cooling plates 212 may be disposed such that one surface and the other surface thereof face the battery cell 210, and each of the battery cells 210 may be disposed such that at least one surface thereof faces the cooling plate 212.

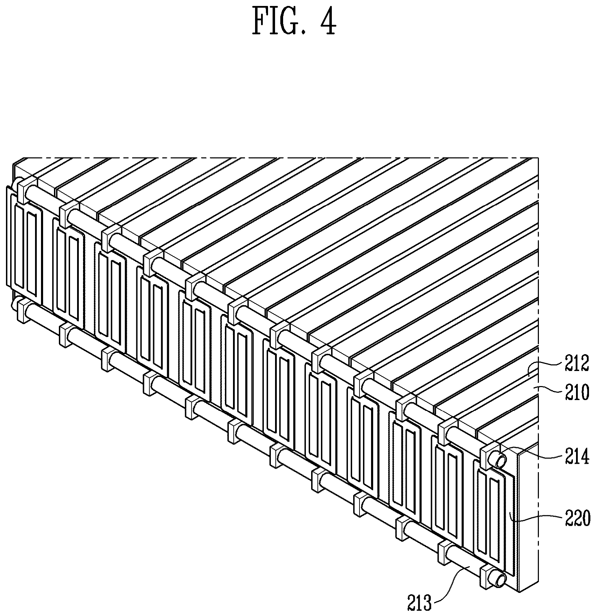

FIG. 4 is a view showing a part of a cell assembly such that one end of the cell assembly is visible.

As shown in FIG. 4, the first busbar assembly 220 is disposed on one side of the cell assembly 200 and may electrically connect one electrode of each of the battery cells 210 and one side of the cooling plate 212.

A configuration in which the first busbar assembly 220 electrically connects one electrode of the battery cell 210 and one side of the cooling plate 212 will be described later.

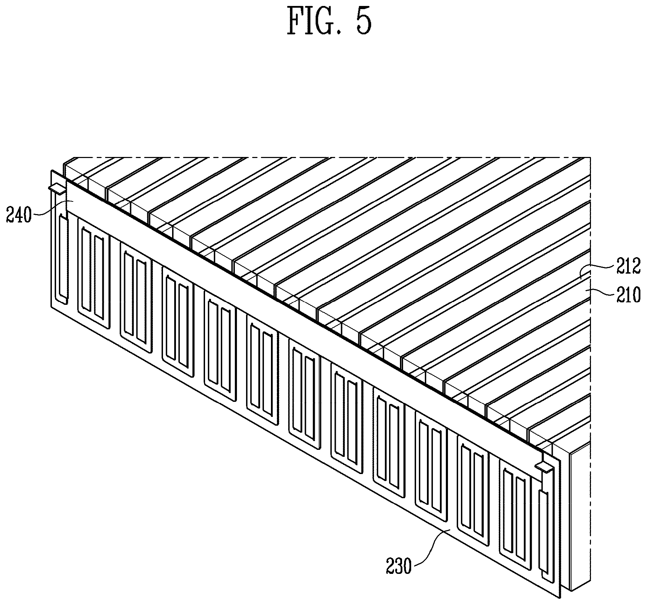

FIG. 5 is a view showing a part of a cell assembly such that the other end of the cell assembly is visible.

As shown in FIG. 5, the second busbar assembly 230 is coupled to the printed wiring circuit board 240 and is disposed on the other side of the cell assembly 200 to electrically connect the other electrode of each of the battery cells 210 and the printed wiring circuit board 240.

In addition, the second busbar assembly 230 may also electrically connect the other side of the cooling plate 212 and the printed wiring circuit board 240.

As such, the second busbar assembly 230 may electrically connect one electrode of each of the battery cells 210 and the printed wiring circuit board 240 by electrically connecting the other side of the cooling plate 212 and the printed wiring circuit board 240.

A configuration in which the second busbar assembly 230 electrically connects the other electrode of the battery cell 210 and the printed wiring circuit board 240, and a configuration in which the second busbar assembly 230 electrically connects the other side of the cooling plate 212 and the printed wiring circuit board 240 will be described later.

Meanwhile, as shown in FIG. 5, the printed wiring circuit board 240 may be coupled to the second busbar assembly 230 and may measure a voltage of at least one of the battery cells 210.

That is, since one electrode of at least one of the battery cells 210 is electrically connected to the printed wiring circuit board 240 through the cooling plate 212, and the other electrode of the battery cell 210 is electrically connected to the printed wiring circuit board 240, the printed wiring circuit board 240 may measure a voltage of at least one of the battery cells 210.

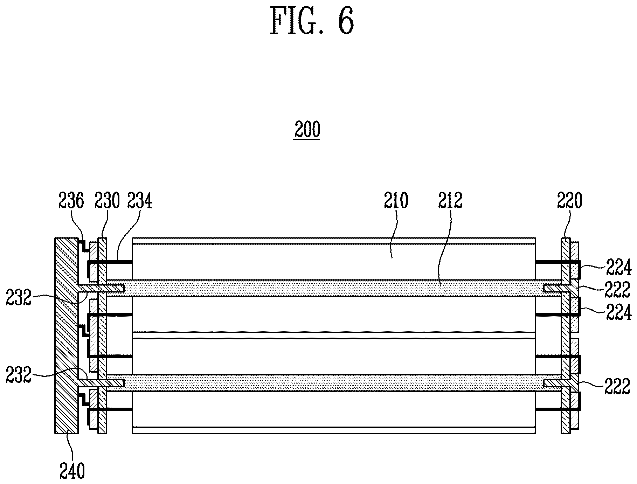

FIG. 6 is a view showing the cell assembly as viewed from a direction perpendicular to a direction in which a plurality of battery cells are stacked.

Specifically, referring to FIG. 6, a configuration in which the voltage of each of the battery cells 210 is measured by the printed wiring circuit board 240 will be described.

As shown in FIG. 6, a cooling plate 212 may be disposed between the plurality of stacked battery cells 210, and the first busbar assembly 220 may be disposed at a position adjacent to one electrode of the battery cell 210.

The first busbar assembly 220 may include a plurality of first electrically conductive members 222 for electrically connecting one electrode of each of the battery cells 210 and one side of the cooling plate 212.

For example, as shown in FIG. 6, one side of a first wire 224 installed in the first busbar assembly 220 may be connected to one electrode of the battery cell 210, and the other side of the first wire 224 may be connected to the first electrically conductive member 222.

The first electrically conductive member 222 may be electrically connected to one electrode of the battery cell 210 by being in contact with one side of the first wire 224 at one side, and may be electrically connected to one side of the cooling plate 212 by being in contact at the other side thereof.

At this time, the first electrically conductive member 222 may have one side coupled to the first busbar assembly 220 and the other side coupled to one side of the cooling plate 212, so that the first busbar assembly 220 can be coupled to the first cooling plate 212.

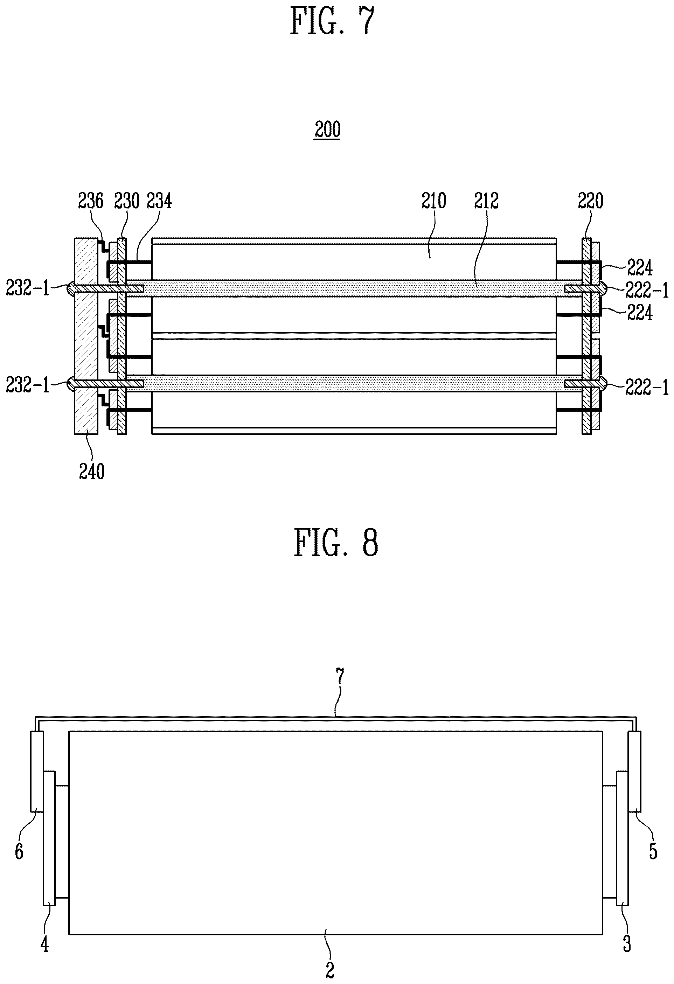

FIG. 7 is a view showing the cell assembly of FIG. 6 including an electrically conductive member formed as a bolt.

For example, as shown in FIG. 7, the first electrically conductive member 222 may be formed as a first bolt 222-1 screwed to the first busbar assembly 220 and the cooling plate 212.

Meanwhile, as shown in FIG. 6, the second busbar assembly 230 may be disposed at a position adjacent to the other electrode of the battery cell 210.

The second busbar assembly 230 may electrically connect the other electrode of each of the battery cells 210 and the printed wiring circuit board 240.

For example, as shown in FIG. 6, one side of a second wire 234 installed in the second busbar assembly 230 may be connected to the other electrode of the battery cell 210.

One side of a third wire 236 installed in the second busbar assembly 230 may be connected to the other side of the second wire 234, and the other side of the third wire 236 may be connected to the printed wiring circuit board 240.

That is, the other electrode of the battery cell 210 may be electrically connected to the printed wiring circuit board 240 through the second wire 234 and the third wire 236.

In addition, the second busbar assembly 230 may include a plurality of second electrically conductive members 232 for electrically connecting the printed wiring circuit board 240 and the other side of the cooling plate 212.

As shown in FIG. 6, the second electrically conductive member 232 may be electrically connected to one electrode of the battery cell 210 by being in contact with the other side of the cooling plate 212, and may be electrically connected to the printed wiring circuit board 240 by being in contact with the printed wiring circuit board 240.

At this time, the second electrically conductive member 232 may have one side coupled to the other side of the cooling plate 212 and the other side coupled to the printed wiring circuit board 240, and at least a part thereof may be supported by the second busbar assembly 230, so that the printed wiring circuit board 240 is coupled to the second busbar assembly 230 and the second busbar assembly 230 is coupled to the cooling plate 212.

For example, as shown in FIG. 7, the second electrically conductive member 232 may be formed as a second bolt 232-1 screwed to the printed wiring circuit board 240, the second busbar assembly 230, and the cooling plate 212.

As such, the printed wiring circuit board 240 is electrically connected to the other electrode of the battery cell 210 through the second busbar assembly 230, and is electrically connected to one electrode of the battery cell 210 through the cooling plate 212 and the second electrically conductive member 232 included in the second busbar assembly 230, so that the voltage of the battery cell 210 can be measured.

That is, even without a flexible printed circuit board, the battery assembly 1 according to an embodiment of the present disclosure can measure the voltage of each of the battery cells 210 by being provided with only one printed wiring circuit board 240.

FIG. 8 is a view schematically showing a conventional cell assembly capable of measuring a voltage of a battery cell.

Referring to FIG. 8, a conventional cell assembly is provided with a third busbar assembly 3 on one side of a plurality of stacked battery cells 2, and a fourth busbar assembly 4 on the other side.

A first printed wiring circuit board 5 electrically connected to one electrode of each of the battery cells 2 is installed in the third busbar assembly 3, and a second printed wiring circuit board 6 electrically connected to the other electrode of each of the battery cells 2 is installed in the fourth busbar assembly 4, and a flexible printed circuit board 7 is configured to electrically connect the first printed wiring circuit board 5 and the second printed wiring circuit board 6.

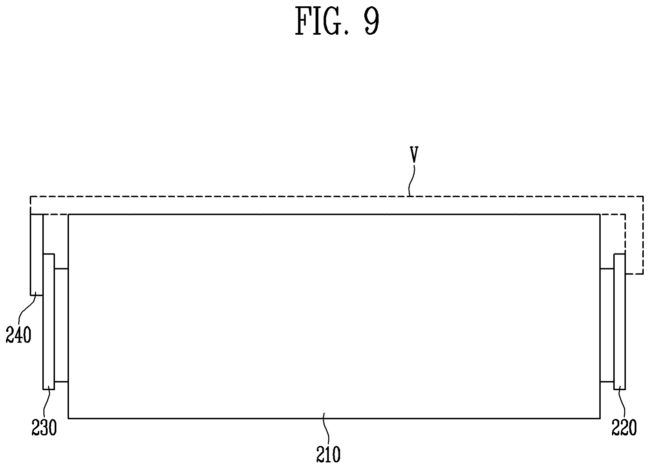

FIG. 9 is a view schematically showing a cell assembly of the battery assembly according to an embodiment of the present disclosure.

In contrast, referring to FIG. 9, the cell assembly 200 of the battery assembly 1 according to an embodiment of the present disclosure is provided with a first busbar assembly 220 on one side of the plurality of stacked battery cells 210 and the cooling plate 212, and a second busbar assembly 230 on the other side.

The second busbar assembly 230 is provided with a printed wiring circuit board 240 electrically connected to the other electrode of each of the battery cells 210.

At this time, since the cooling plate 212 formed of an electrically conductive material performs a function of electrically connecting one electrode of the battery cell 210 and the printed wiring circuit board 240, a separate printed wiring circuit board may not be installed in the first busbar assembly 220, and a flexible printed circuit board may also not be installed.

That is, the cell assembly 200 of the battery assembly 1 according to an embodiment of the present disclosure can more effectively utilize a space V in which a printed wiring circuit board and a flexible printed circuit board would otherwise have to be installed in the conventional cell assembly, so that the battery assembly 1 can increase the number of battery cells 210 accommodated or increase the volume of the battery cells 210 accommodated by utilizing the space V, thereby increasing the energy density of the battery assembly 1.

Meanwhile, each of the battery cells 210 of the cell assembly 200 is formed such that an exhaust hole for discharging gas is formed on a surface facing the lower plate 110, so that the gas discharged from the exhaust hole can be effectively discharged to the outside of the case 100.

Specifically, as shown in FIG. 1, the lower plate 110 is formed with a communication hole 112 communicating with the outside of the case 100.

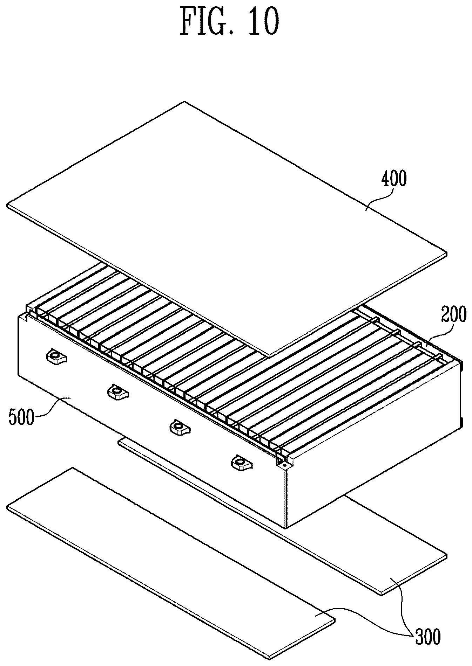

FIG. 10 is a view showing a cell assembly in which an adhesive layer, a first sealing member, and a second sealing member are coupled.

As shown in FIG. 10, the cell assembly 200 may be adhered to the lower plate 110 by being coupled with an adhesive layer 300 such that an exhaust hole is formed at a position facing the communication hole 112, with a portion of a lower surface of the cell assembly 200, except for a portion facing the communication hole, bonded to the lower plate 110.

In addition, the cell assembly 200 may be coupled with a first sealing member 400 on an upper surface facing the upper plate 130, and may be coupled with a second sealing member 500 at a portion adjacent to one electrode and a portion adjacent to the other electrode of each of the battery cells 210.

That is, the cell assembly 200 may be wrapped such that the remaining portion of the lower surface, except for the portion in which the exhaust hole is to be formed, is sealed, so that the exhaust hole through which gas is discharged may be formed on the lower surface facing the lower plate 110.

Accordingly, gas discharged to the lower surface of the cell assembly 200 is effectively moved to the communication hole 112 formed in the lower plate 110 facing the lower surface, and can be discharged to the outside of the case 100 through the communication hole 112.

Hereinafter, the operation and effects of the battery assembly according to an embodiment of the present disclosure will be described.

The cell assembly 200 is accommodated in the receiving space S of the battery assembly 1.

At this time, the cell assembly 200 is sealed except for a predetermined portion of the lower surface so that gas can be discharged through the lower surface, and the lower plate 110 of the case 100 is formed with a communication hole 112 at a position facing the lower surface, so that gas discharged from the battery cell 210 of the cell assembly 200 can be effectively discharged to the outside of the case 100.

In addition, the case 100 may be provided with a buffer member on the side plates 120 to prevent deformation of the shape caused by the cell assembly 200, which increases in volume due to expansion of the battery cells 210.

Meanwhile, the printed wiring circuit board 240 of the cell assembly 200, which can measure the voltage of the battery cells 210, is configured to be electrically connected to the other electrode of the battery cells 210 through the second busbar assembly 230.

The printed wiring circuit board 240 is also configured to be electrically connected to one electrode of the battery cells 210 through the cooling plate 212 and the second electrically conductive members 232 included in the second busbar assembly 230.

That is, since the cell assembly 200 is configured to include only one printed wiring circuit board, the efficiency of space utilization of the battery assembly 1 is improved, and the energy density of the battery assembly 1 can be increased.

As such, the battery assembly according to the present disclosure provides an effect of being able to increase the energy density of the battery assembly, since the cell assembly is configured to be provided with one flexible printed circuit board, thereby accommodating a larger number of battery cells inside the battery assembly.

In addition, since each of the battery cells is configured to discharge gas toward the lower plate formed with a communication hole, the effect of effectively discharging gas emitted from the battery cells to the outside of the battery assembly is provided.

Furthermore, since a buffer member that contracts in response to an increase in volume of the cell assembly is installed in the case, the effect of preventing deformation of the shape of the case caused by expansion of the battery cells is provided.

It is understood by those skilled in the art that the plurality of exemplary embodiments described above are specific examples of the following aspects.

Aspect 1. A battery assembly comprising: a cell assembly comprising: a plurality of battery cells, a printed circuit board configured to measure a voltage of at least one of the battery cells; and a cooling plate disposed to face the battery cells, comprising an electrically conductive material, wherein one electrode of each of the battery cells is electrically connected to the printed circuit board through the cooling plate, and another electrode of each of the battery cells is electrically connected to the printed circuit board.

Aspect 2. The battery assembly according to aspect 1, wherein the battery assembly comprises a case, and wherein the case comprises a receiving space, optionally wherein the cooling plate comprises a flow path through which a cooling material flows.

Aspect 3. The battery assembly according to aspect 1 or 2, wherein the cell assembly comprises: a first busbar assembly disposed at one side of the cell assembly and configured to electrically connect one electrode of each of the battery cells with one side of the cooling plate; and a second busbar assembly coupled to the printed circuit board and disposed at another side of the cell assembly, the second busbar assembly being configured to electrically connect another electrode of each of the battery cells with the printed circuit board, and wherein the second busbar assembly electrically connects another side of the cooling plate with the printed circuit board so as to electrically connect one electrode of each of the battery cells with the printed circuit board.

Aspect 4. The battery assembly according to aspect 3, wherein the first busbar assembly comprises a plurality of first electrically conductive members configured to electrically connect one electrode of each of the plurality of battery cells with one side of the cooling plate.

Aspect 5. The battery assembly according to aspect 4, wherein each of the plurality of first electrically conductive members has one side coupled to the first busbar assembly and another side coupled to one side of the cooling plate, optionally wherein a first electrically conductive member comprises a first bolt screw-coupled to the first busbar assembly and the cooling plate.

Aspect 6. The battery assembly according to any one of aspects 3 to 5, wherein the second busbar assembly comprises a plurality of second electrically conductive members configured to electrically connect the printed circuit board with another side of the cooling plate.

Aspect 7. The battery assembly according to aspect 6, wherein each of the second electrically conductive members has one side coupled to another side of the cooling plate and another side coupled to the printed circuit board, and at least a portion thereof is supported by the second busbar assembly, optionally wherein the second electrically conductive member comprises a second bolt screw-coupled to the printed circuit board, the second busbar assembly, and the cooling plate.

Aspect 8. The battery assembly according to any one of aspects 3 to 7, wherein a plurality of the cooling plates are disposed such that one surface and another surface of the cooling plates thereof face the battery cells, and each of the plurality of battery cells is disposed such that at least one surface thereof faces the cooling plate.

Aspect 9. The battery assembly according to aspect 8, wherein the case comprises a lower plate, a side plate connected to the lower plate to form the receiving space together with the lower plate, and an upper plate coupled to the side plate to seal the receiving space, optionally wherein a discharge hole for discharging gas is formed on a surface facing the lower plate, and wherein the lower plate is formed with a communication hole communicating with an outside of the case so that the gas discharged from the discharge hole is discharged to the outside of the case.

Aspect 10. The battery assembly according to aspect 9, wherein the cell assembly is configured such that the discharge hole is formed at a position facing the communication hole, and wherein a portion of a lower surface of the cell assembly except for a portion facing the communication hole is bonded to the lower plate by being coupled with an adhesive layer.

Aspect 11. The battery assembly according to aspect 10, wherein the adhesive layer comprises a first sealing member coupled to an upper surface facing the upper plate, and a second sealing member coupled to a portion adjacent to one electrode and a portion adjacent to the other electrode of each of the battery cells.

Aspect 12. The battery assembly according to any one of aspects 2 to 11, wherein at least a part of a space of the receiving space, except for a space in which the cell assembly is disposed, is filled with a flame-retardant material, optionally wherein the flame-retardant material comprises silica gel.

Aspect 13. The battery assembly according to aspect 12, wherein a first buffer member is installed on an inner circumferential surface of a first plate located at one end in a predetermined direction of the side plates in which the plurality of battery cells are stacked, wherein a second buffer member is installed on an inner circumferential surface of a second plate located at the other end in the predetermined direction of the side plates, and wherein the first buffer member and the second buffer member are formed to be compressed by being pressed by the cell assembly when the plurality of battery cells expand and a volume of the cell assembly increases.

Aspect 14. The battery assembly according to any one of aspects 2 to 13, wherein an inlet through which a cooling material flows in and an outlet through which the cooling material is discharged are formed in the case, and wherein the inlet and the outlet are connected through the flow path formed in each of the cooling plates, so that the cooling material introduced through the inlet moves along the flow path and is discharged through the outlet.

Aspect 15. A cooling plate for providing temperature control within a battery assembly, comprising: a substrate that comprises a first surface and a second surface, each of the first and second surfaces comprising an electrically conductive material, wherein the substrate is configured to be positioned between a first battery cell and a second battery cell that are stacked in a predetermined direction, such that the first surface contacts the first battery cell and the second surface contacts the second battery cell; a first electrical connection configured to receive an input from an electrode of the first battery cell via a printed circuit board; a second electrical connection configured to receive an input from an electrode of the second battery cell via the printed circuit board; and a flow path through the substrate that is configured for passage of a cooling material received from outside of the cooling plate.

The foregoing description of the present disclosure is intended to be illustrative, and it will be understood by those skilled in the art that various changes in form and detail may be made without departing from the technical spirit or essential characteristics of the present disclosure. Therefore, the embodiments described above should be understood as being illustrative in all respects and not restrictive. For example, each component described as being implemented in a singular form may be implemented in a distributed form, and likewise, components described as being distributed may also be implemented in a combined form.

The scope of the present disclosure is indicated by the claims that follow, rather than the foregoing detailed description, and it should be understood that all modifications or variations derived from the meaning and scope of the claims and their equivalents are to be included within the scope of the present disclosure.

## Claims

1. A battery assembly comprising:
a cell assembly comprising:
a plurality of battery cells,
a printed circuit board configured to measure a voltage of at least one of the battery cells; and
a cooling plate disposed to face the battery cells, comprising an electrically conductive material,
wherein one electrode of each of the battery cells is electrically connected to the printed circuit board through the cooling plate, and another electrode of each of the battery cells is electrically connected to the printed circuit board.

2. The battery assembly according to claim 1, wherein the battery assembly comprises a case, and wherein the case comprises a receiving space, optionally wherein the cooling plate comprises a flow path through which a cooling material flows.

3. The battery assembly according to claim 1 or 2, wherein the cell assembly comprises:
a first busbar assembly disposed at one side of the cell assembly and configured to electrically connect one electrode of each of the battery cells with one side of the cooling plate; and
a second busbar assembly coupled to the printed circuit board and disposed at another side of the cell assembly, the second busbar assembly being configured to electrically connect another electrode of each of the battery cells with the printed circuit board,
and wherein the second busbar assembly electrically connects another side of the cooling plate with the printed circuit board so as to electrically connect one electrode of each of the battery cells with the printed circuit board.

4. The battery assembly according to claim 3, wherein the first busbar assembly comprises a plurality of first electrically conductive members configured to electrically connect one electrode of each of the plurality of battery cells with one side of the cooling plate.

5. The battery assembly according to claim 4, wherein each of the plurality of first electrically conductive members has one side coupled to the first busbar assembly and another side coupled to one side of the cooling plate,
optionally wherein a first electrically conductive member comprises a first bolt screw-coupled to the first busbar assembly and the cooling plate.

6. The battery assembly according to any one of claims 3 to 5, wherein the second busbar assembly comprises a plurality of second electrically conductive members configured to electrically connect the printed circuit board with another side of the cooling plate.

7. The battery assembly according to claim 6, wherein each of the second electrically conductive members has one side coupled to another side of the cooling plate and another side coupled to the printed circuit board, and at least a portion thereof is supported by the second busbar assembly, optionally wherein the second electrically conductive member comprises a second bolt screw-coupled to the printed circuit board, the second busbar assembly, and the cooling plate.

8. The battery assembly according to any one of claims 3 to 7, wherein a plurality of the cooling plates are disposed such that one surface and another surface of the cooling plates thereof face the battery cells, and each of the plurality of battery cells is disposed such that at least one surface thereof faces the cooling plate.

9. The battery assembly according to claim 8, wherein the case comprises a lower plate, a side plate connected to the lower plate to form the receiving space together with the lower plate, and an upper plate coupled to the side plate to seal the receiving space,
optionally wherein a discharge hole for discharging gas is formed on a surface facing the lower plate, and wherein the lower plate is formed with a communication hole communicating with an outside of the case so that the gas discharged from the discharge hole is discharged to the outside of the case.

10. The battery assembly according to claim 9,
wherein the cell assembly is configured such that the discharge hole is formed at a position facing the communication hole, and
wherein a portion of a lower surface of the cell assembly except for a portion facing the communication hole is bonded to the lower plate by being coupled with an adhesive layer.

11. The battery assembly according to claim 10, wherein the adhesive layer comprises a first sealing member coupled to an upper surface facing the upper plate, and a second sealing member coupled to a portion adjacent to one electrode and a portion adjacent to the other electrode of each of the battery cells.

12. The battery assembly according to any one of claims 2 to 11, wherein at least a part of a space of the receiving space, except for a space in which the cell assembly is disposed, is filled with a flame-retardant material, optionally wherein the flame-retardant material comprises silica gel.

13. The battery assembly according to claim 12, wherein a first buffer member is installed on an inner circumferential surface of a first plate located at one end in a predetermined direction of the side plates in which the plurality of battery cells are stacked,
wherein a second buffer member is installed on an inner circumferential surface of a second plate located at the other end in the predetermined direction of the side plates, and
wherein the first buffer member and the second buffer member are formed to be compressed by being pressed by the cell assembly when the plurality of battery cells expand and a volume of the cell assembly increases.

14. The battery assembly according to any one of claims 2 to 13, wherein an inlet through which a cooling material flows in and an outlet through which the cooling material is discharged are formed in the case, and wherein the inlet and the outlet are connected through the flow path formed in each of the cooling plates, so that the cooling material introduced through the inlet moves along the flow path and is discharged through the outlet.

15. A cooling plate for providing temperature control within a battery assembly, comprising:
a substrate that comprises a first surface and a second surface, each of the first and second surfaces comprising an electrically conductive material, wherein the substrate is configured to be positioned between a first battery cell and a second battery cell that are stacked in a predetermined direction, such that the first surface contacts the first battery cell and the second surface contacts the second battery cell;
a first electrical connection configured to receive an input from an electrode of the first battery cell via a printed circuit board;
a second electrical connection configured to receive an input from an electrode of the second battery cell via the printed circuit board; and
a flow path through the substrate that is configured for passage of a cooling material received from outside of the cooling plate.
